# EUROPÄISCHE PATENTANMELDUNG

(11) **EP 2 434 635 A1**
(43) Veröffentlichungstag der Anmeldung: **28.03.2012**
(21) Anmeldenummer: 10180704.8
(22) Anmeldetag: 28.09.2010
(51) Int. Cl.: H02P 8/18, H02P 8/20, H02P 8/22, H03F 3/217, H03G 3/30

(54) **Antriebsvorrichtung für eine medizinische Pumpe mit einem Schrittmotor**

(71) Anmelder: Fresenius Kabi Deutschland GmbH, 61352 Bad Homburg (DE)
(72) Erfinder: Krater, Jörg, 99974, Reiser (DE); Mielack, Peter, 99334 Elleben (DE)
(74) Vertreter: Richly, Erik

(57) **Zusammenfassung**

Die Erfindung betrifft eine Antriebsvorrichtung für eine medizinische Pumpe, insbesondere eine Infusionspumpe oder eine enterale Ernährungspumpe, mit einem Zwei-Phasen-Schrittmotor zum Antreiben der medizinischen Pumpe und einer Steuereinrichtung zum Ansteuern des Zwei-Phasen-Schrittmotors. Dabei ist vorgesehen, dass die Steuereinrichtung (23) ausgebildet ist, ein im Wesentlichen sinusförmiges Eingangssignal (W1) und ein im Wesentlichen kosinusförmiges Eingangssignal (W2) zu erzeugen, und einen Klasse-D-Verstärker (5) zum Verstärken der Eingangssignale (W1, W2) und zum Ansteuern des Zwei-Phasen-Schrittmotors (20) mit den Eingangssignalen (W1, W2) aufweist. Auf diese Weise wird eine Antriebsvorrichtung mit einem Schrittmotor geschaffen, die im Betrieb eine geringe Geräuschentwicklung bei dennoch akzeptablem Wirkungsgrad aufweist.

## Beschreibung

Die Erfindung betrifft eine Antriebsvorrichtung für eine medizinische Pumpe, insbesondere eine Infusionspumpe oder eine enterale Ernährungspumpe, nach dem Oberbegriff des Anspruchs 1.

Eine derartige Antriebsvorrichtung weist einen Zwei-Phasen-Schrittmotor zum Antreiben der medizinischen Pumpe und eine Steuereinrichtung zum Ansteuern des Zwei-Phasen-Schrittmotors auf.

Schrittmotoren kommen heutzutage in unterschiedlichsten Anwendungen zum Einsatz. Ein Schrittmotor ähnelt in seiner prinzipiellen Funktionsweise einem Synchronmotor. Bei einem Schrittmotor wird ein um eine Drehachse drehbarer Rotor durch ein gesteuertes, schrittweise rotierendes magnetisches Feld eines Stators schrittweise verdreht, indem der Rotor dem außen angelegten Feld folgt, was zur Folge hat, dass der Schrittmotor ohne Sensoren zur Positionsrückmeldung (Drehgeber oder ähnliche Sensoren) betrieben werden kann. Im Vergleich zu herkömmlichen Bauformen von Synchronmotoren weisen Schrittmotoren in der Regel eine deutlich höhere Polpaarzahl auf und können im Gegensatz zu beispielsweise Servomotoren (in der Regel Gleichstrom- oder Synchronmotoren mit Positionsgeber, die auf die gewünschte Position eingeregelt werden müssen) in einfacher Weise betrieben werden.

Unterschiedliche Typen von Schrittmotoren sind bekannt:
- Bei einem Permanentmagnetschrittmotor weist der Stator einen Spulen tragenden Weicheisenkern auf, während der Rotor durch einen oder mehrere Dauermagnete mit in Umfangsrichtung sich abwechselnden Polen verwirklicht ist. Im Betrieb des Permanentmagnetschrittmotors folgt der dauermagnetische Rotor dem durch die stromdurchflossenen Spulen erzeugten magnetischen Feld des Stators nach und richtet sich entsprechend des magnetischen Feldes so aus, dass eine Drehbewegung entsteht. Beim Permanentmagnetschrittmotor ist die Anzahl der Pole (und damit die Auflösung zur schrittweisen Verstellung) begrenzt.
- Bei einem Reluktanzschrittmotor besteht der Rotor im Vergleich zu einem Permanentmagnetschrittmotor aus einem gezahnten Weicheisenkern. Beim Reluktanzschrittmotor weist der Rotor nach dem Abschalten des Statorstroms und somit nach dem Abschalten des magnetischen Fels des Stators kein Magnetfeld auf. Nur bei eingeschaltetem Statorstrom fließt ein magnetischer Fluss durch den Weicheisenkern des Rotors. Die Drehbewegung des Rotors kommt zustande, weil vom gezahnten Stator der nächstliegende Zahn des Rotors zur Verringerung des magnetischen Widerstands angezogen wird. Weil der Reluktanzschrittmotor keine Permanentmagnete enthält, hat er im Gegensatz zum Permanentmagnetschrittmotor kein oder zumindest nur ein vernachlässigbares Rastmoment bei ausgeschaltetem Strom.
- Ein Hybridschrittmotor vereint die Eigenschaften beider Bauformen, indem der Rotor neben einem oder mehreren Permanentmagneten auch einen gezahnten Weicheisenkranz aufweist.

Bei der Mehrzahl von heutzutage erhältlichen Schrittmotoren handelt es sich um Hybridschrittmotoren.

Schrittmotoren werden heutzutage in der Regel mit elektronischen Schaltern betrieben. Elektronische Schrittmotortreiber erzeugen dabei aus je einem digitalen Takt- und Richtungssignal eine Phasenabfolge (Sequenz), die erforderlich ist, um ein Drehfeld zu erzeugen. Die auf einer Leiterplatte angeordneten Treiberbaugruppen sind unmittelbar am Motor oder in dessen Nähe angeordnet, um Störemissionen gering zu halten. Integrierte Schaltkreise erzeugen die Sequenz, messen den durch die Spulen fließenden Statorstrom und regeln diesen entsprechend eines Vorgabewertes, der beispielsweise bei einem Stillstand oder bei einer Beschleunigung oder einem Bremsen des Schrittmotors verschieden sein kann.

Mit einer so genannten Choppersteuerung betriebene bipolare Schrittmotoren sind niederohmig. Der Statorstrom wird mit einem Hysterese-Schaltregler für jeden Teilschritt geregelt, indem jede Spule mit einer Frequenz von z.B. mehreren 10 kHz (so genannte Chopperfrequenz) an- und abgeschaltet wird. Die Induktivität der Spulen des Stators sollte dabei, weil sie einer Stromänderung entgegenwirkt, bei großen Drehzahlen und für eine entsprechend hohe erforderliche Dynamik gering sein. Aufgrund des Schaltbetriebes sind die Verlustleistungen in der Elektronik gering.

Die Verwendung von elektronisch geschalteten Schrittmotoren hat den Nachteil, dass diese aufgrund ihres geschalteten Betriebs und beeinflusst auch durch das insbesondere bei Permanentmagnetschrittmotoren vorhandene Rastmoment sich schrittweise bewegen, daher im Betrieb zu Vibrationen neigen und auch Bauteile, mit denen sie verbunden sind, in Schwingungen versetzen können. Insbesondere kann eine medizinische Pumpe, die einen solchen Schrittmotor verwendet, gegebenenfalls zu Vibrationen angeregt werden. Mit den Vibrationen geht eine Geräuschentwicklung im Betrieb des Schrittmotors einher, die störend sein kann.

Um die Vibrationsanregung und Geräuschentwicklung im Betrieb des Schrittmotors zu reduzieren, kann die Schrittweite eines Schrittmotors verkleinert werden. Je kleiner die Schrittweite, desto geringer sind in der Regel die im Betrieb des Schrittmotors auftretenden Schwingungen.

Um bei einem Schrittmotor den Schrittwinkel zu verkleinern, wird herkömmlich eine elektronische Schrittteilung vorgenommen, bezeichnet auch als Mikroschrittbetrieb. Bei dieser werden die Phasenströme zweier aufeinanderfolgender Phasen des Schrittmotors nicht nur an- bzw. ausgeschaltet, sondern in bestimmten Stufen geschaltet. Es ergeben sich ein gestuftes sinusförmiges Eingangssignal für die eine Phase und ein gestuftes kosinusförmiges Eingangssignal für die andere Phase des Schrittmotors, mit denen der Schrittmotor angesteuert wird. Je kleiner die elektronische Schrittteilung, desto kleiner die Schrittweite im Betrieb des Schrittmotors, desto ruhiger der Lauf des Schrittmotors und desto geringer die im Betrieb des Schrittmotors auftretenden Schwingungen.

Je kleiner die Schrittteilung und entsprechend je kleiner die Schrittweite wird, desto mehr nähert sich der Kurvenverlauf der Eingangssignale einer Sinus- bzw. Kosinus-Funktion an. Je kleiner die Schrittweite gewählt wird, desto teurer werden jedoch auch die integrierten Schaltungen für den elektronischen Schrittmotortreiber.

Zudem verschlechtert sich der Wirkungsgrad des Schrittmotors, wenn -wie bei Reluktanzschrittmotoren oder bei Hybridschrittmotoren - das Rastmoment (im stromlosen Zustand) vernachlässigbar gering oder zumindest reduziert ist, weil die Magnetfeldkopplung zwischen Rotor und Stator gegenüber Permanentmagnetschrittmotoren bzw. Hybridschrittmotoren mit hohem Rastmoment verschlechtert ist, was zu einer hohen Verlustleistung und im Betrieb entstehender Wärme führt, die abgeleitet werden muss.

Aus der DE 198 45 044 A1 ist ein Zwei-Phasen-Schrittmotor in Form eines Reluktanzschrittmotors bekannt, bei dem auf Statorpole Spulen gewickelt sind, die im Betrieb von einem Strom durchflossen werden. Ein Rotor wird hierbei durch Ansteuern der Spulen mit sinusförmigen oder im Wesentlichen sinusförmigen Eingangssignalen in eine Drehbewegung versetzt.

Bei einem aus der EP 1 187 302 B1 bekannten Schrittmotor nach Art eines Permanentmagnetschrittmotors ist ein Permanentmagnete tragender Rotor als Außenrotor um einen Stator drehbar angeordnet. Die EP 1 187 302 B1 beschreibt ein motorisches Antriebssystem beispielsweise für ein Golfcart, bei dem die Phasen durch gestufte Sinusfunktionen angesteuert werden.

Bei einem aus der US 2008/0169731 A1 bekannten Hybridschrittmotor werden zusätzliche Schritte zwischen aufeinanderfolgenden Phasen des Motors für eine ruhige Bewegung und eine hohe Genauigkeit erzeugt. Ein Rotor weist dazu zwei Sätze von Rotorabschnitten auf, die um eine halbe Zahnteilung gegeneinander versetzt sind. Der Schrittmotor wird mit annähernd sinusförmigen Eingangssignalen angesteuert, die gestuften Sinusfunktionen mit kleiner Schrittweite entsprechen.

Aufgabe der vorliegenden Erfindung ist es, eine Antriebsvorrichtung mit einem Schrittmotor bereitzustellen, die im Betrieb eine geringe Geräuschentwicklung bei dennoch akzeptablem Wirkungsgrad aufweist.

Diese Aufgabe wird durch einen Gegenstand mit den Merkmalen des Anspruchs 1 gelöst.

Demnach ist vorgesehen, dass die Steuereinrichtung ausgebildet ist, ein im Wesentlichen sinusförmiges Eingangssignal und ein im Wesentlichen kosinusförmiges Eingangssignal zu erzeugen, und einen Klasse-D-Verstärker zum Verstärken der Eingangssignale und zum Ansteuern des Zwei-Phasen-Schrittmotors mit den Eingangssignalen aufweist.

Die vorliegende Erfindung geht von dem Gedanken aus, zum Ansteuern des Zwei-Phasen-Schrittmotors ein sinusförmiges Eingangssignal und ein kosinusförmiges Eingangssignal zu verwenden, also keine gestuften Eingangssignale.. Dies stellt den Grenzfall für eine unendlich kleine elektronische Schrittteilung dar und führt dazu, dass keine aufwändigen elektronischen Schalter und Schrittmotortreiber verwendet werden müssen, um gestufte Eingangssignale für eine elektronische Schrittteilung zu erzeugen. Dadurch, dass für die Eingangssignale eine Sinusform bzw. Kosinusform verwendet wird, kann die Ansteuerung auf analoge Weise ohne aufwändige elektronische Steuerung erfolgen.

Unter einem sinusförmigen bzw. kosinusförmigen Eingangssignal soll vorliegend verstanden werden, dass das Eingangssignal im Wesentlichen sinusförmig bzw. kosinusförmig ausgebildet ist, also zumindest angenähert einer harmonischen Schwingung entspricht. Abweichungen von einer reinen Sinus- bzw. Kosinusform können hierbei durchaus vorkommen und sind bei realen Bedingungen z.B. infolge eines Rauschens oder von an Schaltungskomponenten auftretenden Verzerrungen nicht vollständig zu vermeiden. Vorzugsweise werden aber Eingangssignale mit einer möglichst reinen Sinus- bzw. Kosinusform erzeugt und zum Antreiben des Zwei-Phasen-Schrittmotors verwendet.

Das sinusförmige Eingangssignal und das kosinusförmige Eingangssignal sollten in ihrer Wellenform im Wesentlichen identisch sein und eine Phasenverschiebung von 90° zueinander aufweisen.

Nach Möglichkeit sollten die Wellenformen der Eingangssignale im Bereich ihrer Wellenberge und Wellentäler keine Unstetigkeiten aufweisen, also beispielsweise nicht infolge eines Übersteuerns des verwendeten Verstärkers an ihren Scheitelpunkten abgeflacht sein.

Dadurch, dass zur Ansteuerung eine Sinusform bzw. Kosinusform für die Eingangssignale verwendet wird und zudem vorzugsweise ein Reluktanzschrittmotor oder ein Hybridschrittmotor mit geringem Rastmoment als Zwei-Phasen-Schrittmotor zum Einsatz kommt, ergibt sich ein ruhiger Lauf des Zwei-Phasen-Schrittmotors bei geringer Geräuschentwicklung im Betrieb, wobei für den Zwei-Phasen-Schrittmotor preiswert erhältliche Bauformen mit preisgünstigen Komponenten zum Einsatz kommen können.

Die Ansteuerung des Zwei-Phasen-Schrittmotors über die Steuereinrichtung mit einem sinusförmigen und einem kosinusförmigen Eingangssignal für die zwei Phasen des Schrittmotors hat zur Folge, dass sich der Wirkungsgrad der Antriebsvorrichtung verschlechtert. Um diesem entgegenzuwirken, kommt ein Klasse-D-Verstärker zum Einsatz, der die von der Steuereinrichtung generierten Eingangssignale verstärkt und zum Ansteuern an den Zwei-Phasen-Schrittmotor weiterleitet.

Bei einem Klasse-D-Verstärker, auch als schaltender Verstärker bezeichnet, handelt es sich um einen elektrischen Verstärker, der als Leistungsverstärker oder als Endstufe zum Einsatz kommt und bei dem ein (analoges) Eingangssignal beispielsweise nach dem Prinzip der Pulsweitenmodulation in modulierter Form als eine Folge von Pulsen dargestellt wird. Diese Pulse können mit einem hohen Wirkungsgrad verstärkt werden, indem der Verstärker im Schaltbetrieb betrieben wird, bei dem die verwendeten elektronischen Schaltelemente (z. B. Transistoren) entweder maximal leitend oder maximal isolierend sind und somit nur zwei Zustände kennen. Weil bei Betrieb der Schaltelemente in diesen beiden Zuständen wenig Verlustleistung erzeugt wird, arbeitet der Klasse-D-Verstärker insgesamt mit einem hohen Wirkungsgrad.

Klasse-D-Verstärker sind vorzugsweise analoge Verstärker, können unter Umständen aber auch als digitale Verstärker aufgebaut sein und finden herkömmlich beispielsweise als Audioverstärker Verwendung.

Durch Verwendung einer Ansteuerung des Zwei-Phasen-Schrittmotors mit sinusförmigen bzw. kosinusförmigen Eingangssignalen (was in Kombination mit der Verwendung eines Schrittmotors mit geringem Rastmoment zu einem schlechten Wirkungsgrad führt) in Kombination mit einem Klasse-D-Verstärker (der einen hohen Wirkungsgrad aufweist) zum Verstärken der Eingangssignale und zum Ansteuern des Zwei-Phasen-Schrittmotors weist die Antriebsvorrichtung insgesamt einen hinreichenden Wirkungsgrad, dabei aber ein sehr ruhiges Laufverhalten auf. Durch Kombination der sinus- bzw. kosinusförmigen Ansteuerung und des Klasse-D-Verstärkers wird somit eine Antriebsvorrichtung mit dem gewünschten ruhigen Laufverhalten und einer geringen Geräuschentwicklung im Betrieb geschaffen.

Die Steuereinrichtung weist vorzugsweise einen Mikrocontroller auf, der ausgebildet ist, ein sinusförmiges Eingangssignal und ein kosinusförmiges Eingangssignal zu erzeugen, die beispielsweise pulsweitenmoduliert sind. Diese pulsweitenmodulierten Eingangssignale werden von einem ersten Filter zu analogen Signalen mit einer Sinusform bzw. Kosinusform demoduliert und dem Klasse-D-Verstärker zugeführt, der an seinem Eingang analoge Signale erfordert.

Der erste Filter ist vorzugsweise als aktiver Filter unter Verwendung von aktiven Komponenten wie Transistoren oder Operationsverstärkern ausgebildet. Aktive Filter, die zum Betrieb der aktiven Komponenten eine eigene Spannungsversorgung benötigen, weisen in der Regel neben den aktiven Komponenten auch passive Komponenten in Form von Widerständen und Kondensatoren auf und können auf Induktivitäten verzichten, so dass Filterelemente mit hohen Güten verwirklicht werden können.

Um eine Filterung und Demodulierung der von dem Mikrocontroller zur Verfügung gestellten Eingangssignale zu erreichen, kommt vorzugsweise ein aktiver Filter höherer Ordnung zum Einsatz, der die demodulierten Eingangssignale in möglichst störungsfreier Weise an den Klasse-D-Verstärker weiterleitet.

Der Klasse-D-Verstärker ist vorteilhafterweise als Zwei-Kanal-Verstärker mit zwei Kanälen ausgebildet, von denen der eine das sinusförmige Eingangssignal und der andere das kosinusförmige Eingangssignal verstärkt. Solche Zwei-Kanal-Verstärker sind als Stereo-Audio-Verstärker kostengünstig erhältlich und verstärken die an den Kanälen anliegenden Eingangssignale, die jeweils zur Ansteuerung einer Phase des Zwei-Phasen-Schrittmotors dienen, mit jeweils einem hohen Wirkungsgrad.

Vorzugsweise ist der Klasse-D-Verstärker als Niederfrequenz- (NF) Verstärker mit einem Frequenzbereich beispielsweise zwischen 20 Hz und 25 KHz ausgebildet.

Die Eingangssignale sind nach Durchlaufen des Klasse-D-Verstärkers wiederum pulsweitenmoduliert. Zur Ansteuerung des Zwei-Phasen-Schrittmotors ist der Klasse-D-Verstärker daher vorzugsweise mit einem weiteren, zweiten Filter verbunden, der die vom Klasse-D-Verstärker verstärkten, pulsweitenmodulierten Eingangssignale zu einer sinusförmigen und einer kosinusförmigen Wellenform demoduliert und mit den demodulierten, analogen Eingangssignalen, die einer Sinusform bzw. einer Kosinusform entsprechen, den Zwei-Phasen-Schrittmotor ansteuert.

Während der erste Filter, über den die Eingangssignale dem Klasse-D-Verstärker zur Verstärkung zugeführt werden, vorzugsweise als aktiver Filter ausgebildet ist, um dem Klasse-D-Verstärker eingangsseitig möglichst störungsfreie Eingangssignale zur Verfügung zu stellen, kann der dem Klasse-D-Verstärker nachgeschaltete, zweite Filter, der zur Demodulierung der vom Klasse-D-Verstärker abgegebenen, pulsweitenmodulierten Signale dient, als passiver Filter ausgestaltet sein. Der zweite Filter kann somit kostengünstig unter Verwendung von ausschließlich passiven Komponenten, beispielsweise Widerständen, Spulen und Kondensatoren, ausgebildet sein und demoduliert die von dem Klasse-D-Verstärker abgegebenen pulsweitenmodulierten Signale zu analogen Signalen, die dann als Eingangssignale dem Zwei-Phasen-Schrittmotor zugeführt werden.

Zur Demodulierung der vom Klasse-D-Verstärker abgegebenen Signale ist ein passiver Filter ausreichend, weil aufgrund des Aufbaus des Zwei-Phasen-Schrittmotors mit den am Stator angeordneten, induktiv wirkenden Spulen ohnehin eine Glättung der Signale am Zwei-Phasen-Schrittmotor erfolgt.

Um einen ruhigen Lauf des Schrittmotors zu erhalten, ist, wie bereits gesagt, der Schrittmotor vorzugsweise als Reluktanzschrittmotor mit (im stromlosen Zustand) keinem oder einem zu vernachlässigenden Rastmoment oder als Hybridschrittmotor mit einem geringen Rastmoment ausgestaltet. Vorzugsweise kommt hierbei, als Kompromiss zwischen hoher Laufruhe und gutem Wirkungsgrad, ein Hybridschrittmotor zum Einsatz, der beispielsweise einen Schrittwinkel von 1,8 ° aufweist, so dass bei einer Ansteuerung mit sinusförmig bzw. kosinusförmig ausgebildeten Eingangssignalen mit einer Frequenz von 50 Hz der Schrittmotor eine volle Umdrehung pro Sekunde ausführt.

Der Zwei-Phasen-Schrittmotor wird vorzugsweise bipolar betrieben, um den Schrittmotor mit hoher Dynamik betreiben zu können und eine hohe Stromänderungsgeschwindigkeit in den Spulen des Stators zu ermöglichen. Bei bipolarer Betriebsweise weisen die Spulen an den Polen des Stators keinen Mittelabgriff auf, sondern werden abwechselnd in unterschiedliche Stromrichtungen bestromt.

Eine medizinische Pumpe, insbesondere eine Infusionspumpe oder eine enterale Ernährungspumpe, beispielsweise ausgestaltet als peristaltische Pumpe mit einem auf einen Schlauch einwirkenden Pumpenrad, verwendet vorteilhafterweise eine Antriebsvorrichtung der vorangehend beschriebenen Art. Bei medizinischen Pumpen ist ein Pumpenbetrieb mit ruhigem Lauf und geringer Geräuschentwicklung wünschenswert, der in gleichmäßiger, kontrollierter Weise das zu fördernde Fluid bewegt, was durch eine Antriebsvorrichtung der vorangehend beschriebenen Art gewährleistet werden kann.

Der der Erfindung zugrunde liegende Gedanke soll nachfolgend anhand der in den Figuren dargestellten Ausführungsbeispiele näher erläutert werden. Es zeigen:
- Fig. 1: eine schematische Ansicht einer medizinischen Pumpe in Form einer peristaltischen Pumpe;
- Fig. 2: eine schematische Ansicht eines Zwei-Phasen-Schrittmotors;
- Fig. 3A-3C: grafische Ansichten gestufter Eingangssignale herkömmlicher Schrittmotoren;
- Fig. 4: eine grafische Ansicht eines sinusförmigen und eines kosinusförmigen Eingangssignals;
- Fig. 5: ein schematisches Blockschaltbild einer Steuereinrichtung zum Ansteuern des Zwei-Phasen-Schrittmotors;
- Fig. 6: ein schematisches Blockschaltbild eines Klasse-D-Verstärkers und
- Fig. 7: eine grafische Ansicht eines verstärkten, pulsweitenmodulierten Signals des Klasse-D-Verstärkers und des daraus demodulierten Eingangssignals zum Ansteuern einer Phase des Zwei-Phasen-Schrittmotors.

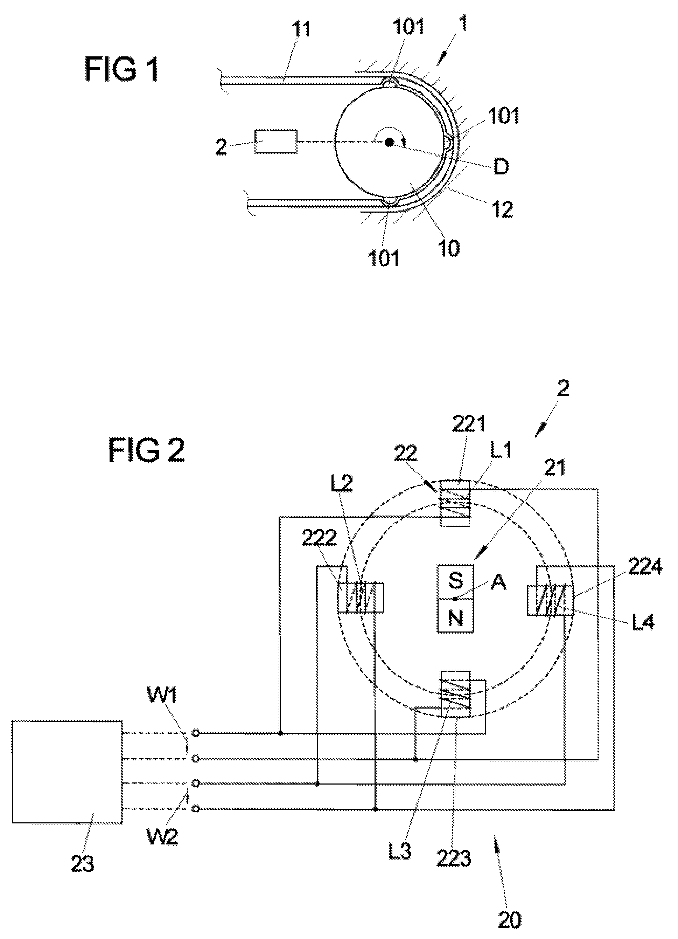

Fig. 1 zeigt in einer schematischen Ansicht eine medizinische Pumpe 1, die als peristaltische Pumpe ausgebildet ist und beispielsweise als Infusionspumpe oder als enterale Ernährungspumpe zum Einsatz kommen kann. Die medizinische Pumpe 1 weist eine Antriebsvorrichtung 2 auf, die beispielsweise über ein Getriebe mit einem um eine Drehachse D drehbaren Pumpenrad 10 verbunden ist. Das Pumpenrad 10 steht über an seinem äußeren Umfang angeordnete Rollelemente 101 mit einem flexiblen Schlauch 11 in Kontakt, der sich zwischen einem federnd gelagerten oder feststehenden Abschnitt 12, beispielsweise einem Gehäuseabschnitt der medizinischen Pumpe 1, einerseits und dem Pumpenrad 10 andererseits erstreckt.

Im Betrieb der medizinischen Pumpe 1 wird das Pumpenrad 10 über die Antriebsvorrichtung 2 in eine Drehbewegung um die Drehachse D versetzt, so dass das Pumpenrad 10 mit seinen Rollelementen 101 entlang des Schlauchs 11 gleitet. Der Schlauch 11 wird auf diese Weise lokal durch die Rollelemente 101 zusammengedrückt und stellt sich anschließend elastisch wieder zurück, so dass ein in dem Schlauch 10 befindliches Fluid in Richtung der Drehbewegung des Pumpenrads 10 in dem Schlauch 11 befördert wird.

Der Schlauch 11 kann einerseits mit einem Fluidcontainer, beispielsweise einem eine Infusionslösung enthaltenden Beutel oder einem Blutbeutel, und andererseits mit einer Gabeeinrichtung, z. B. einem Venenkatheter, verbunden sein.

Die Antriebsvorrichtung 2 treibt das Pumpenrad 10 an und weist hierzu einen Zwei-Phasen-Schrittmotor 20 auf, wie er schematisch in Fig. 2 dargestellt ist. Der Zwei-Phasen-Schrittmotor 20 weist einen Stator mit daran angeordneten Polen 221, 222, 223, 224 und einen um eine Drehachse A zum Stator 22 drehbaren Rotor 21 auf. An den Polen 221, 222, 223, 224 des Stators 22 sind jeweils Spulen L1, L2, L3, L4 angeordnet, die über elektrische Leitungen mit einer Steuereinrichtung 23 verbunden sind und zum Betrieb des Zwei-Phasen-Schrittmotors 20 bestromt werden.

Zwei-Phasen-Schrittmotoren können als Permanentmagnetschrittmotoren, als Reluktanzschrittmotoren oder als Hybridschrittmotoren ausgeführt sein. Bei einem Permanentmagnetschrittmotor ist der Rotor 21 durch einen Permanentmagneten oder eine Mehrzahl von Permanentmagneten mit umfänglich abwechselnd zueinander angeordneten Polen (Nordpol N und Südpol S) ausgebildet. Bei einem Reluktanzschrittmotor besteht der Rotor 21 aus einem gezahnten Weicheisenkern, und bei einem Hybridschrittmotor ist der Rotor 21 durch einen oder mehrere Permanentmagneten und einen daran angesetzten, gezahnten Weicheisenkranz gebildet, in Vereinigung der Bauformen des Permanentmagnetschrittmotors und des Reluktanzschrittmotors.

Das Prinzip des Zwei-Phasen-Schrittmotors 20 basiert darauf, dass der Rotor 21 einem an den Polen 221, 222, 223, 224 generierten Drehfeld in synchroner Weise, ähnlich dem Verhalten eines Synchronmotors, folgt. Der Rotor 21 wird dabei bei Anliegen eines entsprechenden magnetischen Feldes an einem Pol von diesem angezogen und dementsprechend in eine Drehbewegung versetzt. Die Funktionsweise von Zwei-Phasen-Schrittmotoren ist an sich bekannt und soll daher an dieser Stelle nicht näher erörtert werden.

Der Zwei-Phasen-Schrittmotor 20 wird mit zwei Phasen angesteuert, die elektronisch über die Steuereinrichtung 23 angelegt werden. Hierbei werden, bei der schematischen Ansicht gemäß Fig. 2, das aus den Spulen 221, 223 bestehende erste Spulenpaar mit einem ersten Eingangssignal W1 und das aus den Spulen 222, 224 bestehende zweite Spulenpaar mit einem zweiten Eingangssignal W2 angesteuert.

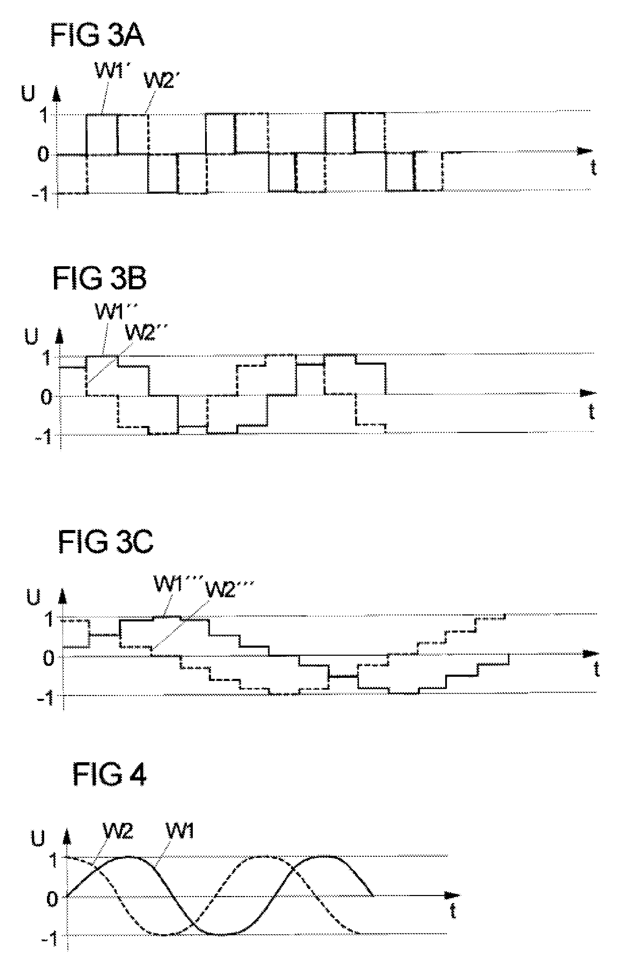

Herkömmlich erfolgt die Ansteuerung beispielsweise über gestufte Sinus- und Kosinussignale, mittels derer eine elektronische Schrittteilung vorgenommen wird, die eine Verkleinerung des Schrittwinkels des Zwei-Phasen-Schrittmotors 20 über die durch die physikalisch vorgesehenen Pole des Stators 22 und/oder Rotors 21 hinaus bewirkt. Beispielhafte Ausgestaltungen solcher gestufter Eingangssignale sind in Fig. 3A bis 3C dargestellt. Die gestuften Eingangssignale W1', W2' gemäß Fig. 3A verwirklichen hierbei einen Betrieb mit vier Schritten pro Periode des Eingangssignals W1', W2'. Bei den gestuften Eingangssignalen W1 ", W2" gemäß Fig. 3B ist die Schrittteilung durch die weitere Stufung der Signale um den Faktor 2 verkleinert, so dass sich 8 Schritte pro Periode des Eingangssignals W1", W2" ergeben. Bei den gestuften Eingangssignalen W1"', W2"' gemäß Fig. 3C wiederum ist die Schrittteilung erneut um den Faktor 2 verkleinert, so dass sich 16 Schritte pro Periode des Eingangssignals W1 "', W2"' ergeben.

Mittels der gestuften Eingangssignale W1', W2'; W1 ", W2"; W1"', W2"' nimmt der Rotor 21 im Betrieb des Zwei-Phasen-Schrittmotors 20 schrittweise auch Zwischenstellungen zwischen den physikalisch ausgebildeten Polen des Rotors 21 und des Stators 22 ein. Die Schrittteilung kann hierbei durch weitere Stufen der Eingangssignale W1', W2'; W1", W2"; W1"', W2"' weiter verkleinert und somit die Schrittweite verringert werden, wobei mit Verkleinerung der Schrittteilung die Wellenform der Eingangssignale W1', W2'; W1", W2"; W1"', W2"' immer weiter einer Sinus- oder Kosinusform angenähert wird (siehe Fig. 3C).

Die Verkleinerung der Schrittweite hat zur Folge, dass im Betrieb des Zwei-Phasen-Schrittmotors 20 die Anregung von Resonanzen reduziert und Vibrationen des Zwei-Phasen-Schrittmotors 20 und der medizinischen Pumpe 1 im Betrieb verringert werden. Elektronische Schrittmotortreiber zur Ansteuerung mit sehr fein gestuften Eingangssignalen sind jedoch vergleichsweise teuer.

In Abkehr von herkömmlichen Zwei-Phasen-Schrittmotoren werden im Rahmen der vorliegenden Erfindung keine elektronischen Schalter verwendet, sondern die Ansteuerung des Zwei-Phasen-Schrittmotors 20 erfolgt in nicht-geschalteter, analoger Weise über ein sinusförmiges und ein kosinusförmiges Eingangssignal W1, W2, wie in Fig. 4 dargestellt. Wird zudem ein Zwei-Phasen-Schrittmotor 20 in Form eines Reluktanzschrittmotors, der in stromlosem Zustand kein Rastmoment aufweist, oder eines Hybridschrittmotors, der ein lediglich geringes Rastmoment aufweist, verwendet, so kann eine Antriebsvorrichtung 2 geschaffen werden, die ein ruhiges Laufverhalten aufweist und bei der die Anregung von Vibrationen und Resonanzen im Betrieb der Antriebsvorrichtung 2 weitestgehend vermieden werden können.

Das Rastmoment des Zwei-Phasen-Schrittmotors 20 ergibt sich daraus, dass aufgrund der magnetischen Anziehungskraft zwischen Stator 22 und Rotor 21 der Rotor 21 schrittweise in solchen Lagen, in der mit einem Pol einem Pol des Stators 22 exakt gegenübersteht, vorzugsweise verharrt und sozusagen einrastet. Ein Reluktanzschrittmotor weist in stromlosem Zustand kein oder ein vernachlässigbares Rastmoment auf, weil dessen Rotor 21 aus einem Weicheisenkern gefertigt ist und somit kein eigenes Magnetfeld aufweist. Liegt kein Strom an den Spulen 221, 222, 223, 224 des Zwei-Phasen-Schrittmotors 20 an, so kann sich der Rotor 21 damit bei einem Reluktanzschrittmotor frei gegenüber dem Stator 22 drehen.

Fig. 4 zeigt in einer grafischen Ansicht die Eingangssignale W1, W2, die zur Ansteuerung der zwei Phasen des Zwei-Phasen-Schrittmotors 20 verwendet werden. Diese werden über die Steuereinrichtung 23 bereitgestellt, wobei zur Ansteuerung nach Möglichkeit für die eine Phase eine exakte Sinusform und für die andere Phase eine exakte Kosinusform verwendet werden.

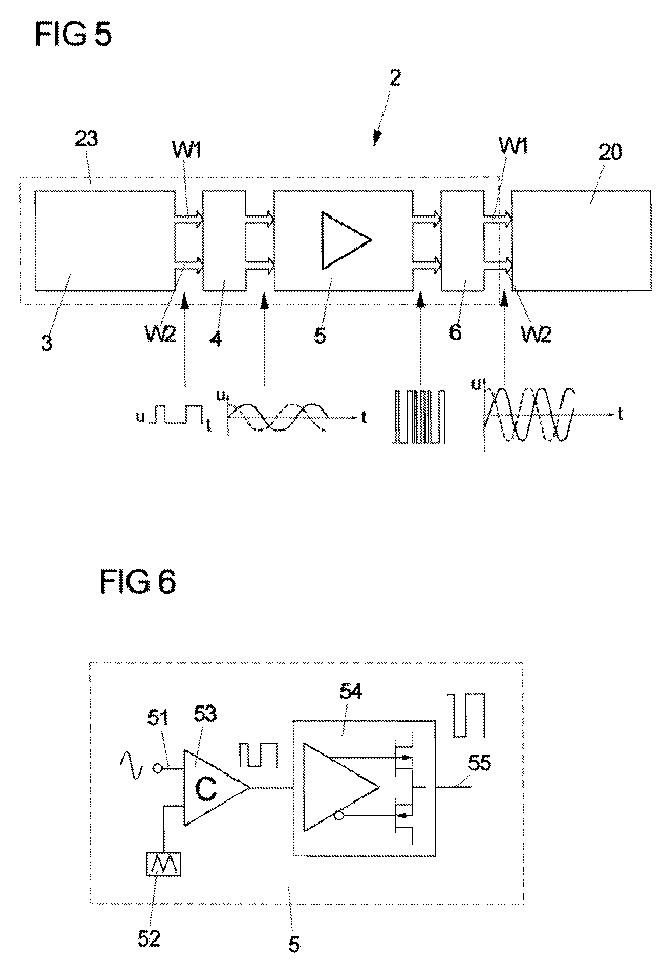

Ein schematisches Blockschaltbild der Steuereinrichtung 23 zeigt Fig. 5. Die Steuereinrichtung 23 weist einen Mikrocontroller 3 in Form eines integrierten Schaltkreises auf, der die Eingangssignale W1, W2 als pulsweitenmodulierte Signale erzeugt und an einen Filter 4 abgibt. Der Filter 4, der als aktiver Filter höherer Ordnung unter Verwendung aktiver Komponenten wie Transistoren oder Operationsverstärker und passiver Komponenten wie Widerstände und Kondensatoren ausgebildet ist, demoduliert aus den pulsweitenmodulierten Signalen des Mikrocontrollers 3 die in den Signalen modulierten, analogen Wellenformen und leitet diese an einen Verstärker 5 weiter.

Der Verstärker ist als Klasse-D-Verstärker 5 ausgebildet, verstärkt die analogen Eingangssignale W1, W2 und gibt die verstärkten Signale wiederum in pulsweitenmodulierter Form an einen weiteren Filter 6 ab, der diese demoduliert und die verstärkten Eingangssignale W1, W2 in analoger Form zur Ansteuerung an den Zwei-Phasen-Schrittmotor 20 leitet.

Die Eingangssignale W1, W2 werden somit durch den Mikrocontroller 3 zunächst in pulsweitenmodulierter Form erzeugt, durch den ersten Filter 4 zu analogen Signalen demoduliert, durch den Klasse-D-Verstärker 5 erneut pulsweitenmoduliert und verstärkt, durch den Filter 6 wiederum demoduliert und schließlich in analoger Form zur Ansteuerung des Zwei-Phasen-Schrittmotors 20 verwendet, wie dies grafisch unter dem Blockschaltbild entsprechend dargestellt ist.

Nach dem Filter 6 weisen die Eingangssignale W1, W2 eine analoge Sinusform bzw. Kosinusform auf und werden als analoge Signale zur Ansteuerung des Zwei-Phasen-Schrittmotors 20 verwendet.

Wird als Zwei-Phasen-Schrittmotor 20 ein Schrittmotor in Form eines Reluktanzmotors mit (im stromlosen Zustand) vernachlässigbaren Rastmoment oder ein Hybridschrittmotor mit geringem Rastmoment verwendet, ist der Wirkungsgrad des Zwei-Phasen-Schrittmotors 20 vergleichsweise gering. Um dennoch eine Antriebsvorrichtung 2 zu erhalten, deren Wirkungsgrad in einem akzeptablen Bereich liegt und durch die Steuereinrichtung 23 nicht entscheidend beeinträchtigt ist, wird als Verstärker 5 ein Klasse-D-Verstärker eingesetzt, der aufgrund seiner Betriebsweise einen hohen Wirkungsgrad aufweist.

Ein schematisches Blockschaltbild eines Klasse-D-Verstärkers 5 ist in Fig. 6 dargestellt. Der Klasse-D-Verstärker 5 weist einen Komparator 53 auf, an dessen einem Eingang 51 das zu verstärkende, vom Filter 4 abgegebene Eingangssignal W1, W2 anliegt und an dessen anderem Eingang ein Dreieckgenerator 52 angeschlossen ist. Der Komparator 53 ist ausgangsseitig mit einer Endstufe 54 verbunden, die das vom Komparator 53 abgegebene Signal verstärkt und über einen Ausgang 55 an den Filter 6 abgibt.

Bei dem Klasse-D-Verstärker 5 wird das an dem Eingang 51 anliegende, vom Filter 4 abgegebene Eingangssignal W1, W2, das als analoges Signal an dem Komparator 53 anliegt, durch den Komparator 53 mit einem vom Dreiecksgenerator 52 abgegebenen Dreiecksignal verglichen. Der Komparator 53 erzeugt hierbei - abhängig davon, ob das Dreiecksignal des Dreiecksgenerators 52 in seinem Momentanwert größer ist als das Eingangssignal W1, W2 an dem Eingang 51 - ein Rechtecksignal, das er an die Endstufe 54 abgibt.

Über das vom Komparator 53 abgegebene Rechtecksignal, das einem pulsweitenmodulierten Signal entspricht, werden die Endstufe 54 und darin angeordnete Leistungstransistoren mit Rechteckpulsen unterschiedlicher Länge und durch die Frequenz des Dreiecksignals des Dreieckgenerators 52 vorgegebener Frequenz angesteuert (die Frequenz des Dreiecksignals des Dreiecksgenerators 52 kann in der Größenordnung von 250 KHz bis zu einigen MHz liegen). Aufgrund des gepulsten Ausgangssignals des Komparators 53 werden die Leistungstransistoren der Endstufe 54 mit hoher Frequenz ein- und ausgeschaltet und damit nicht, wie bei Verstärkern anderer Klassen üblich, linear betrieben. Dies hat den Vorteil, dass die Leistungstransistoren vorzugsweise in solchen Bereichen arbeiten, in denen ihr Wirkungsgrad hoch ist, so dass die Endstufe 54 insgesamt einen hohen Wirkungsgrad aufweist und nur eine geringe Verlustleistung und eine entsprechend geringe Wärme erzeugt.

Das verstärkte, gepulste Signal wird über den Ausgang 55 an den Filter 6 abgegeben, der das pulsweitenmodulierte Signal demoduliert und als analoges, sinusförmiges bzw. kosinusförmiges Eingangssignal W1, W2 an den Zwei-Phasen-Schrittmotor 20 abgibt.

Damit der Klasse-D-Verstärker 5 das zu verstärkende Eingangssignal W1, W2 nicht verzerrt, ist die Schaltfrequenz, vorgegeben durch die Frequenz des Dreiecksgenerators 52, oberhalb der höchsten Signalfrequenz zu wählen. Sie kann beispielsweise bei 400 KHz liegen.

Der Klasse-D-Verstärker 5 kann in einfacher, kostengünstiger Weise insbesondere ohne teuren und schweren Transformator aufgebaut werden. Er weist einen hohen Wirkungsgrad von beispielsweise etwa 90% und sehr geringe Verzerrungen (kleiner Klirrfaktor) auf.

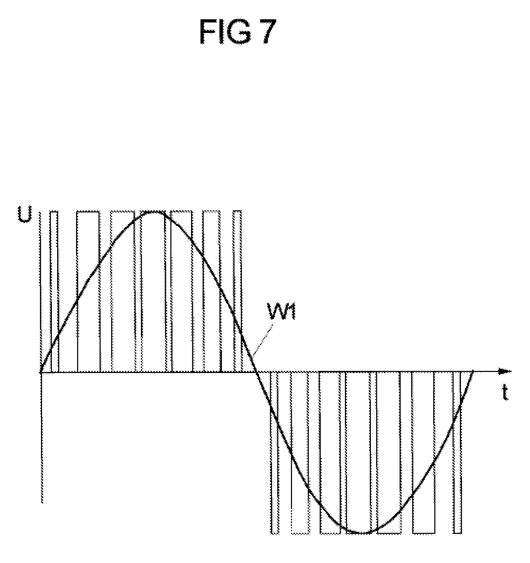

Das von dem Klasse-D-Verstärker 5 am Ausgang 55 abgegebene, pulsweitenmodulierte Signal wird durch den Filter 6 demoduliert, wie in Fig. 7 grafisch dargestellt ist. Es ergibt sich am Ausgang des Filters 6 ein sinusförmiges Eingangssignal W1 zum Ansteuern der einen Phase des Zwei-Phasen-Schrittmotors 20 und ein kosinusförmiges Eingangssignal W2 zum Ansteuern der anderen Phase des Zwei-Phasen-Schrittmotors 20.

Dadurch, dass ein Klasse-D-Verstärker 5, der insbesondere als Niederfrequenz (NF)-Verstärker mit einem Frequenzbereich zwischen 20 Hz und 25 KHz ausgeführt sein kann, in Kombination mit einer Ansteuerung des Zwei-Phasen-Schrittmotors 20 über ein analoges sinus- bzw. kosinusförmiges Eingangssignal W1, W2 verwendet wird und zudem ein Zwei-Phasen-Schrittmotor 20 mit keinem oder lediglich einem geringen Rastmoment zum Einsatz kommt, ergibt sich ein ruhiger Lauf bei gleichzeitig akzeptablem Wirkungsgrad der Antriebsvorrichtung 2. Eine aufwändige elektronische Treiberschaltung zum Ansteuern des Zwei-Phasen-Schrittmotors 20 mit gestuften Eingangssignalen kann entfallen. Die Geräuschentwicklung der Antriebsvorrichtung 2 der medizinischen Pumpe 1 im Betrieb ist reduziert, und eine Anregung von Vibrationen und Schwingungen der Antriebsvorrichtung 2 und Bauteilen der medizinischen Pumpe 1 kann wirksam unterdrückt werden.

Der der Erfindung zugrunde liegende Gedanke ist nicht auf die vorangehend geschilderten Ausführungsbeispiele beschränkt, sondern lässt sich grundsätzlich auch bei gänzlich anders gearteten Ausführungsformen verwirklichen.

So kann beispielsweise der Klasse-D-Verstärker auch eine andere Bauform und Funktionsweise als die beschriebene aufweisen und beispielsweise andere Modulationsverfahren, beispielsweise eine Pulsdichtemodulation (Pulsfrequenzmodulation), eine Delta-Sigma-Modulation oder eine so genannte Sliding-Mode-Regelung verwenden.

Die Bauform des beschriebenen Zwei-Phasen-Schrittmotors ist grundsätzlich beliebig, wobei der Zwei-Phasen-Schrittmotor vorzugsweise ein geringes Rastmoment aufweist. Die konkrete Ausgestaltung des Rotors und Stators mit geeigneter Polteilung kann in Abhängigkeit von dem gewünschten Einsatz gewählt werden.

### Bezugszeichenliste

- 1: Medizinische Pumpe
- 10: Pumpenrad
- 101: Rollelemente
- 11: Schlauch
- 12: Feststehender Abschnitt
- 2: Antriebsvorrichtung
- 20: Schrittmotor
- 21: Rotor
- 22: Stator
- 221-224: Pol
- 23: Steuereinrichtung
- 3: Mikrocontroller
- 4: Filter
- 5: Verstärker
- 51: Eingang
- 52: Dreiecksgenerator
- 53: Komparator
- 54: Endstufe
- 55: Ausgang
- 6: Filter
- A: Drehachse
- D: Drehachse
- L1-L4: Spule
- N: Nordpol
- S: Südpol
- W1, W2: Eingangssignal
- W1', W2'; W1", W2"; W1"', W2"': Eingangssignal

## Patentansprüche

1. Antriebsvorrichtung für eine medizinische Pumpe, insbesondere eine Infusionspumpe oder eine enterale Ernährungspumpe, mit
- einem Zwei-Phasen-Schrittmotor zum Antreiben der medizinischen Pumpe und
- einer Steuereinrichtung zum Ansteuern des Zwei-Phasen-Schrittmotors,
**dadurch gekennzeichnet,**
**dass** die Steuereinrichtung (23) ausgebildet ist, ein im Wesentlichen sinusförmiges Eingangssignal (W1) und ein im Wesentlichen kosinusförmiges Eingangssignal (W2) zu erzeugen, und einen Klasse-D-Verstärker (5) zum Verstärken der Eingangssignale (W1, W2) und zum Ansteuern des Zwei-Phasen-Schrittmotors (20) mit den Eingangssignalen (W1, W2) aufweist.

2. Antriebsvorrichtung nach Anspruch 1, **dadurch gekennzeichnet, dass** die Steuereinrichtung (23) einen Mikrocontroller (3) umfasst.

3. Antriebsvorrichtung nach Anspruch 1 oder 2, **dadurch gekennzeichnet, dass** der Mikrocontroller (3) ausgebildet ist, ein sinusförmiges Eingangssignal (W1) und ein kosinusförmiges Eingangssignal (W2) zu erzeugen.

4. Antriebsvorrichtung nach Anspruch 3, **dadurch gekennzeichnet, dass** die vom Mikrocontroller (3) erzeugten Eingangssignale (W1, W2) pulsweitenmoduliert sind.

5. Antriebsvorrichtung nach Anspruch 3 oder 4, **dadurch gekennzeichnet, dass** der Mikrokontroller (3) mit einem ersten Filter (4) verbunden ist, der die Eingangssignale (W1, W2) filtert und die Eingangssignale (W1, W2) dem Klasse-D-Verstärker (5) zuführt.

6. Antriebsvorrichtung nach Anspruch 5, **dadurch gekennzeichnet, dass** der erste Filter (4) als aktiver Filter ausgebildet ist.

7. Antriebsvorrichtung nach einem der vorangehenden Ansprüche, **dadurch gekennzeichnet, dass** der Klasse-D-Verstärker (5) zwei Kanäle aufweist, von denen der eine das sinusförmige Eingangssignal (W1) und der andere das kosinusförmige Eingangssignal (W2) verstärkt.

8. Antriebsvorrichtung nach einem der vorangehenden Ansprüche, **dadurch gekennzeichnet, dass** der Klasse-D-Verstärker (5) als Niederfrequenz-Verstärker mit einem Frequenzbereich zwischen 20 Hz und 25 kHz ausgebildet ist.

9. Antriebsvorrichtung nach einem der vorangehenden Ansprüche, **dadurch gekennzeichnet, dass** die vom Klasse-D-Verstärker (5) verstärkten Eingangssignale (W1, W2) pulsweitenmoduliert sind.

10. Antriebsvorrichtung nach einem der vorangehenden Ansprüche, **dadurch gekennzeichnet, dass** der Klasse-D-Verstärker mit einem zweiten Filter (6) verbunden ist, der die vom Klasse-D-Verstärker (5) verstärkten, pulsweitenmodulierten Eingangssignale (W1, W2) zu einer sinusförmigen und einer kosinusförmigen Wellenform demoduliert und damit den Zwei-Phasen-Schrittmotor (20) ansteuert.

11. Antriebsvorrichtung nach Anspruch 10, **dadurch gekennzeichnet, dass** der zweite Filter (6) als passiver Filter ausgebildet ist.

12. Antriebsvorrichtung nach einem der vorangehenden Ansprüche, **dadurch gekennzeichnet, dass** der Zwei-Phasen-Schrittmotor (20) als Hybridschrittmotor ausgebildet ist.

13. Antriebsvorrichtung nach einem der vorangehenden Ansprüche, **dadurch gekennzeichnet, dass** der Zwei-Phasen-Schrittmotor (20) bipolar betrieben wird.

14. Medizinische Pumpe, **gekennzeichnet durch** eine Antriebsvorrichtung (2) nach einem der vorangehenden Ansprüche.

15. Medizinische Pumpe nach Anspruch 14, **dadurch gekennzeichnet, dass** die medizinische Pumpe (1) als peristaltische Pumpe ausgebildet ist.
